# EUROPEAN PATENT APPLICATION

(11) **EP 4 790 710 A1**
(43) Date of publication of application: **12.08.2026**
(21) Application number: 26156381.1
(22) Date of filing: 04.02.2026
(51) Int. Cl.: G11C 11/56, G11C 13/00

(54) **MEMORY DEVICE STORING DATA IN TERNARY CELLS USING TWO LEVELS OF CODING**

(30) Priority: 11.02.2025 US 202563757103 P; 18.12.2025 US 202519425822
(71) Applicant: MICRON TECHNOLOGY, INC., Boise ID 83707 (US)
(72) Inventor: MUZZETTO, Riccardo, 20862 Arcore (Monza Brianza) (IT); LAURENT, Christophe Vincent Antoine, 20864 Agrate Brianza (Monza Brianza) (IT)
(74) Representative: Pio, Federico

(57) **Abstract**

Systems, methods, and apparatus related to memory devices that store data. In one approach, a memory device includes at least one memory array having ternary memory cells. A controller stores data in pairs of the ternary cells. Each value in the data is stored by writing a respective pair of cells using a first level of coding. The controller defines a special value and identifies instances of the special value in the data. An additional bit is stored for each identified special value using a second level of coding.

## Description

### FIELD OF THE TECHNOLOGY

At least some embodiments disclosed herein relate to memory devices in general, and more particularly, but not limited to memory devices that store data in memory cells using two levels of coding.

### BACKGROUND

Memory devices are widely used to store information in various electronic devices such as computers, wireless communication devices, cameras, digital displays, and the like. Information is stored by programming different states of a memory device. For example, binary devices have two states, often denoted by a logic "1" or a logic "0". In other systems, more than two states may be stored. To access the stored information, a component of the electronic device may read, or sense, the stored state in the memory device. To store information, a component of the electronic device may write, or program, the state in the memory device.

Various types of memory devices exist, including magnetic hard disks, random access memory (RAM), read only memory (ROM), dynamic RAM (DRAM), synchronous dynamic RAM (SDRAM), ferroelectric RAM (FeRAM), magnetic RAM (MRAM), resistive RAM (RRAM), flash memory, phase change memory (PCM), and others. Memory devices may be volatile or non-volatile. Non-volatile memory cells may maintain their stored logic state for extended periods of time even in the absence of an external power source. Volatile memory cells may lose their stored state over time unless they are periodically refreshed by an external power source.

A storage device is an example of a memory device. Typical computer storage devices have controllers that receive data access requests from host computers and perform programmed computing tasks to implement the requests in ways that may be specific to the media and structure configured in the storage devices. In one example, a memory controller manages data stored in memory and communicates with a computer device. In some examples, memory controllers are used in solid state drives for use in mobile devices or laptops, or media used in digital cameras.

Firmware can be used to operate a memory controller for a particular storage device. In one example, when a computer system or device reads data from or writes data to a memory device, it communicates with the memory controller.

Memory devices typically store data in memory cells. In some cases, memory cells exhibit non-uniform, variable electrical characteristics that may originate from various factors including statistical process variations, cycling events (e.g., read or write operations on the memory cells), or a drift (e.g., a change in resistance of a chalcogenide alloy), among others.

In one example, reading a set of data (e.g., a codeword, a page) is carried out by determining a read voltage (e.g., an estimated median of threshold voltages) of memory cells that store the set of data. In some cases, a memory device may include an array of PCM cells arranged in a 3D architecture, such as a cross-point architecture to store the set of data. PCM cells in a cross-point architecture may represent a first logic state (e.g., a logic 1, a SET state) associated with a first set of threshold voltages, or a second logic state (e.g., a logic 0, a RESET state) associated with a second set of threshold voltages. In some cases, data may be stored using encoding (e.g., error correction coding (ECC)) to recover data from errors in the data stored in the memory cells.

For resistance variable memory cells (e.g., PCM cells), one of a number of states (e.g., resistance states) can be set. For example, a memory cell may be programmed to one of two states (e.g., logic 1 or 0), which can depend on whether the cell is programmed to a resistance above or below a particular level. As an additional example, various resistance variable memory cells can be programmed to one of multiple different states corresponding to multiple data states, e.g., 10, 01, 00, 11, 111, 101, 100, 1010, 1111, 0101, 0001, etc.

The state of a resistance variable memory cell can be determined (e.g., read) by sensing current through the cell responsive to an applied interrogation voltage. The sensed current, which varies based on the resistance of the cell, can indicate the state of the cell (e.g., the binary data stored by the cell). The resistance of a programmed resistance variable memory cell can drift (e.g., shift) over time. Resistance drift can result in erroneous sensing of a resistance variable memory cell (e.g., a determination that the cell is in a state other than that to which it was programmed, among other issues).

A PCM cell, for example, may be programmed to a reset state (amorphous state) or a set state (crystalline state). A reset pulse (e.g., a pulse used to program a cell to a reset state) can include a relatively high current pulse applied to the cell for a relatively short period of time such that the phase change material of the cell melts and rapidly cools, resulting in a relatively small amount of crystallization. Conversely, a set pulse (e.g., a pulse used to program a cell to a set state) can include a relatively lower current pulse applied to the cell for a relatively longer time interval and with a slower quenching speed, which results in an increased crystallization of the phase change material.

A programming signal can be applied to a selected memory cell to program the cell to a target state. A read signal can be applied to a selected memory cell to read the cell (e.g., to determine the state of the cell). The programming signal and the read signal can be current and/or voltage pulses, for example.

### SUMMARY

The invention is as defined in independent claims; optional embodiments are defined in dependent claims.

### BRIEF DESCRIPTION OF THE DRAWINGS

The embodiments are illustrated by way of example and not limitation in the figures of the accompanying drawings in which like references indicate similar elements.
**FIG. 1** shows a memory device that accesses a memory array when performing read or write operations, in accordance with some embodiments.
**FIG. 2** shows a memory array having memory cells accessed using a common wordline, in accordance with some embodiments.
**FIG. 3** shows an example of a memory cell that includes a select device, in accordance with some embodiments.
**FIG. 4** shows a memory device configured with a read manager to access memory cells in a memory array, according to one embodiment.
**FIG. 5** shows a memory cell with a bitline driver and a wordline driver configured to apply voltages, according to one embodiment.
**FIG. 6** shows an exemplary normal quantile (NQ) plot representing the statistical distributions of threshold voltages of memory cells.
**FIG. 7** shows an exemplary three-dimensional memory array structure having wordlines configured in a comb structure, in accordance with some embodiments.
**FIG. 8** shows a coding table for storing data using a pair of ternary cells, in accordance with some embodiments.
**FIG. 9** shows a coding table for storing data using one level of coding, in accordance with some embodiments.
**FIG. 10** shows a coding table for storing data that corresponds to a defined value using two levels of coding, in accordance with some embodiments.
**FIG. 11** shows coding for a data flow to store additional bits using two levels of coding, in accordance with some embodiments.
**FIG. 12** shows scanning of a data flow to identify special values for storing additional bits using two levels of coding, in accordance with some embodiments.
**FIG. 13** shows exemplary improvements in storage density for memory cells having various multiple levels per cell by storing additional bits using two levels of coding, in accordance with some embodiments.
**FIG. 14** shows exemplary improvements in storage density for ternary cells by storing additional bits using two levels of coding, in accordance with some embodiments.
**FIG. 15** shows a method for storing user data using pairs of ternary cells, in accordance with some embodiments.

### DETAILED DESCRIPTION

The following disclosure describes various embodiments for memory devices that store data in memory cells (e.g., cells each storing data in three or more states or levels) using two levels of coding. In one embodiment, the data is stored using pairs of ternary cells. In one example, the memory cells are chalcogenide memory cells. The ternary cells of each pair are programmed according to a coding scheme that uses two levels of coding to increase storage density. This enables storing additional bits.

Memory storage often uses power-of-two coding. In one example, a memory cell has two data states or levels. This memory cell has a density of one bit per cell. To increase storage density, memory cells having a higher power-of-two coding using multiple data states or levels can be used. For example, a memory cell can have four states or levels.

However, in some cases, a memory technology may not be sufficiently reliable for operation at a density of four levels per cell or higher. For example, the sigma (standard deviation) of the memory cell threshold voltage distribution may be too large for a particular memory technology, and four levels cannot reliably be used. In such cases, a non-power-of-two coding scheme can be used. For example, ternary memory cells having three states or levels (e.g., LO, L1, L2) per cell can be used to store data. For example, each ternary cell can be programmed to have one of three different threshold voltages.

Because the use of three levels per cell is not based on power-of-two coding, this can cause some technical problems in implementation. For example, memory density is sub-optimal because the coding scheme has some redundancy in coding. The redundancy might be tolerated to simplify design of the coding circuitry. But this can cause inefficiency in memory storage.

For example, non-power-of-two coding circuitry is complex to build and sub-optimal cell density may be chosen for simplicity. This implies an area overhead to match page dimension. For example, in the case of three levels per cell, it may be simpler to choose storage of three bits within two cells coding. However, if this is done, only 8 out of 9 state or level combinations (e.g., L2/L1, LO/L2, etc.) provided by the two memory cells would be used. This causes the technical problem of inefficient use of layout area and storage resources.

To address the above and other technical problems, a memory device stores data using pairs of ternary cells. In one embodiment, each pair provides 9 level combinations. Three-bit combinations of the data are stored. Each three-bit combination is stored using a pair of cells. Eight different values (e.g., 0, 1, 2, 3, 4, 5, 6, 7) can be stored, each mapping to one combination of the cell levels.

The use of 9 level combinations for coding three bits provides one redundant level combination that is not used for the single level of three-bit coding above. To improve storage density, this redundant level combination is associated with a defined value. The defined value can be arbitrarily selected from the eight values. The defined value is stored using two levels of coding.

For example, the defined value can be selected by a controller to be 4. Two of the total 9 level combinations are mapped to the defined value. These two-level combinations are mapped to a value of an additional bit (e.g., 0 or 1) that is stored. Values of the data that are not the defined value are stored using one first level of coding. By the foregoing approach, various 3-bit combinations are stored for all values other than the defined value. However, if the 3-bit combination is equal to the defined value, then a total of four bits are stored (the 3-bit combination and an additional bit).

It should be noted that the terms "defined value" and "special value" are used for describing various embodiments herein. The terms "defined value" and "special value" are generally used interchangeably herein.

In one embodiment, a memory device uses chalcogenide cells to store data. A controller stores user data in the cells. The user data corresponding to a defined value (e.g., a special value of 4) is stored using two levels of coding. The other remaining user data (e.g., values of 0, 1, 2, 3, 5, 6, 7) is stored using one level of coding.

In one embodiment, a controller identifies positions of special values in user data received from a host device. The controller associates a respective additional bit to each identified position. The controller stores the user data at the identified positions using a first level of coding, and stores the respective additional bits using a second level of coding.

In one embodiment, a system includes at least one processing device, and at least one memory containing instructions configured to instruct the at least one processing device to: adjust a proportion of special values in data; and store, using pairs of ternary cells, each special value with a respective additional bit. For example, the proportion is changed by inverting all bits of selected incoming codewords. A controller scans the data when received to determine the adjustment to the proportion.

Various advantages are provided by at least some embodiments described herein. For example, storage of data in ternary cells using two-level coding recovers previously lost bits/cell density and associated area overhead.

At least some embodiments herein relate to memory devices that use bipolar operations for a memory array. In one example, bipolar select voltages are used to select memory cells of the memory array. In one example, the memory cells are arranged in a cross-point architecture. In one example, each memory cell is formed using a single select device. In one example, the select device includes a chalcogenide material that switches (e.g., snaps) when a sufficient voltage is applied across the memory cell.

The memory device may, for example, store data used by a host device (e.g., a computing device of an autonomous vehicle, or another computing device that accesses data stored in the memory device). In one example, the memory device is a solid-state drive mounted in an electric vehicle.

In some cases, a memory device may include an array of memory cells arranged in a three-dimensional (3D) architecture, such as a cross-point architecture, to store the set of data. The memory cells in a cross-point architecture may, for example, represent a first logic state (e.g., a logic 1, a SET state) associated with a first set of threshold voltages, or a second logic state (e.g., a logic 0, a RESET state) associated with a second set of threshold voltages.

In other embodiments, the memory cells may be arranged in a three-dimensional (3D) vertical architecture. A 3D vertical architecture may include memory cells located at the crossing between a vertical access line (e.g., a bitline pillar), and each one of a plurality of second access lines (e.g., wordlines), formed in horizontal planes or decks parallel to each other.

More generally, an integrated circuit memory cell, such as a memory cell in a cross-point memory or a 3D vertical array, can be programmed to store data by the way of its state at a voltage applied across the memory cell. For example, if a memory cell is configured or programmed in such a state that allows a substantial current to pass the memory cell at a voltage in a predefined voltage region, the memory cell is considered to have been configured or programmed to store a first bit value (e.g., one or zero); and otherwise, the memory cell is storing a second bit value (e.g., zero or one).

Optionally, a memory cell can be configured or programmed to store more than one bit of data by being configured or programmed, for example, to have a threshold voltage in one of more than two separate voltage regions.

The threshold voltage of a memory cell is such that when the voltage applied across the memory cell is increased to above the threshold voltage, the memory cell switches by changing rapidly or abruptly, snapping (e.g., for a chalcogenide memory cell), or jumping from a non-conductive state to a conductive state. The non-conductive state allows a small leak current to go through the memory cell; and in contrast, the conductive state allows more than a threshold amount of current to go through. Thus, a memory device can use a sensor (e.g., sense amplifier) to detect the change, or determine the conductive/non-conductive state of the memory device at one or more applied voltages, to evaluate or classify the level of the threshold voltage of the memory cell and thus its stored data.

The threshold voltage of a memory cell being configured/programmed to be in different voltage regions can be used to represent different data values stored in the memory cell. For example, the threshold voltage of the memory cell can be programmed to be in any of four predefined voltage regions; and each of the regions can be used to represent the bit values of a different two-bit data item. Thus, when given a two-bit data item, one of the four voltage regions can be selected based on a mapping between two-bit data items and voltage regions; and the threshold voltage of the memory cell can be adjusted, programmed, or configured to be in the selected voltage region to represent or store the given two-bit data item. To retrieve, determine, or read the data item from the memory cell, one or more read voltages can be applied across the memory cell to determine which of the four voltage regions contain the threshold voltage of the memory cell. The identification of the voltage region that contains the threshold voltage of the memory cell provides the two-bit data item that has been stored, programmed, or written into the memory cell.

In one embodiment, a memory device has a memory array including memory cells (e.g., chalcogenide memory cells in a vertically integrated cross-point memory array). The memory device includes bias circuitry to apply voltages to the memory cells when performing read, write, and/or other operations. In one example, the bias circuitry includes decoders to direct the applied voltages to wordlines, gate lines, and/or digit lines. When performing a read operation, sensing circuitry of the memory device is used to read a logic state of the memory cells. In some cases, the sensing circuitry is used during write operations (e.g., for adjusting a write voltage(s)).

It should be noted that the terms "digit lines" and "bit lines" are used for describing various embodiments herein. The terms "digit lines" and "bit lines" are generally used interchangeably herein.

In one example, the controller receives a command (e.g., from a host device) to read data at first and second addresses (e.g., addresses provided from the host with the command). The first address corresponds to first memory cells of the memory array, the second address corresponds to second memory cells of the memory array, and the first and second memory cells are accessed using a common wordline. In one example, the first and second memory cells are in a same tile of the memory array.

In response to receiving the command, the controller biases, using the bias circuitry, a voltage of the wordline to an initial voltage (e.g., a voltage used for a start of a read voltage ramp for a read algorithm of the controller). The controller causes the sensing circuitry to read the first memory cells. This read operation includes increasing a magnitude of the voltage of the wordline from the initial voltage during the ramp.

In one example, an idle mode voltage of the wordline is ground or 0 volts. During a selection phase, the wordline voltage is decreased to an initial voltage of negative 2 volts (-2 V). The read voltage is then ramped in incremental voltage changes of negative 0.2 volts (-0.2 V), for example, until a final maximum read voltage is reached. In one example, this maximum read voltage corresponds to a time at which the controller determines that a condition is satisfied (e.g., a minimum read error rate is achieved, a number or proportion of data memory cells have switched, and/or a number of reference or pattern cells have switched).

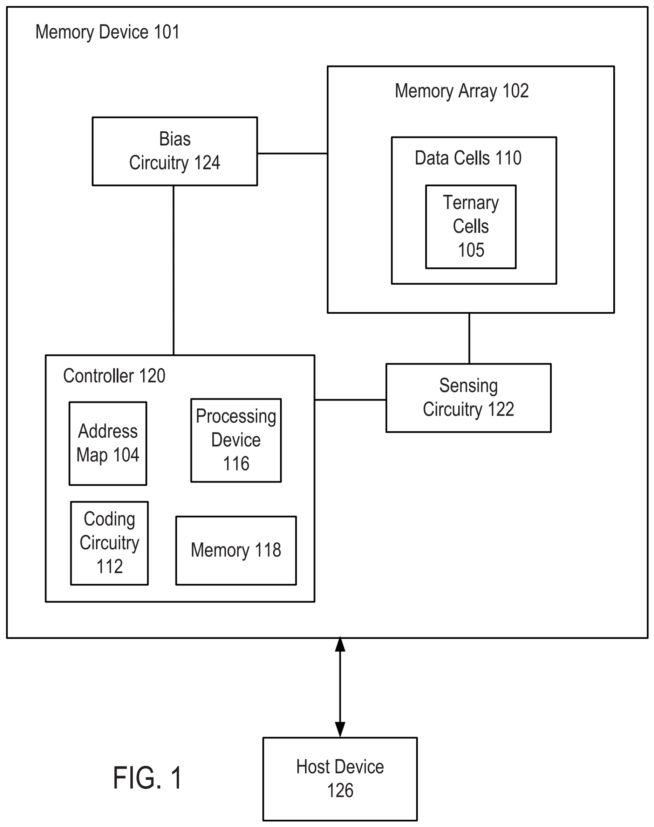

**FIG. 1** shows a memory device that accesses a memory array when performing read or write operations, in accordance with some embodiments. Memory device 101 includes a memory array 102 having data cells 110 (and optionally having pattern cells). The data cells 110 generally store data (e.g., user data stored for host device 126). Access to memory array 102 is managed by controller 120.

Controller 120 includes coding circuitry 112 used to encode and decode data written to and read from data cells 110. In one embodiment, data is stored using ternary cells 105. For example, a three-bit combination is stored using a pair of memory cells 105 per mapping provided by a coding table.

In one embodiment, coding circuitry 112 encodes user data received from host device 126 (e.g., data provided with a write command). Various values of the user data are stored using a first level of encoding. The first level of encoding corresponds to states or levels of a pair of ternary cells. Those values of the user data that correspond to a special value (e.g., 4) can be associated with an additional bit that can be stored using a second level of encoding. The second level of encoding corresponds to a combination of levels of the pair of ternary cells to correspond to the special value. This level combination of the special value corresponds to a redundant level combination of the ternary cell pair that can be used in combination to store a value of the additional bit.

In one embodiment, controller 120 receives, from host device 126, a read command. In response to receiving the read command, controller 120 reads data in parallel from a plurality of partitions of memory array 102. The data is read from each of the partitions, for example, using a streaming mode.

In one embodiment, coding circuitry 112 decodes user data stored in ternary cells 105 (e.g., data requested by a read command from host device 126). Coding circuitry 112 is used to decode data stored in ternary cells 105 that corresponds to an address provided with the read command. In one embodiment, coding circuitry 112 uses a coding table stored in memory 118 to perform encoding/decoding.

In one example, an address map 104 is stored in memory 118 and relates addresses in memory array 102 to physical nodes/features of memory array 102 such as wordlines, gate lines, sensing nodes, etc. In one example, address map 104 stores data indicating those data cells 110 that are accessed using a common node (e.g., a common wordline). Controller 120 uses this data in determining whether to access data cells 110 using a streaming mode or a default mode (e.g., random mode).

Controller 120 reads data from memory cells, for example, using a common wordline (not shown) of memory array 102. Controller 120 sends the read data to host device 126.

In one embodiment, memory device 101 uses reference patterns to select a read voltage for performing read operations (e.g., when operating in a default/random and/or streaming mode). The pattern cells generally store various reference patterns (e.g., a known pattern of all ones (1s)). For example, two reference patterns are associated with each codeword or block stored in data cells 110.

In one example, during a read operation to read a codeword, controller 120 reads the reference patterns associated with the codeword. For example, controller 120 counts a number of pattern cells that snap when being read. Based on the number that snap, controller 120 selects a read voltage for reading the codeword. In one example, the read voltage is a current voltage applied to the pattern cells when a threshold number of cells snap.

In one embodiment, when performing a read operation, bias circuitry 124 applies voltages to the pattern cells. In one example, bias circuitry 124 includes wordline and bitline drivers (not shown) to bias wordlines and bitlines of memory array 102.

Controller 120 determines which of the pattern cells switch. In one example, controller 120 determines that a number of memory cells in the pattern that switch (e.g., threshold or snap) is greater than a threshold.

Sensing circuitry 122 is used to read the pattern cells and data cells 110. In one example, sensing circuitry 122 includes sense amplifiers for sensing a characteristic associated with memory cells of the memory array 102. The characteristic can be, for example, a voltage and/or current associated with a selected memory cell.

In one embodiment, based on determining a number of the pattern cells that switch, controller 120 determines an initial read voltage to use when reading (e.g., user data) from data cells 110 that are associated with the pattern cells.

Controller 120 includes one or more processing devices 116 and memory 118. In one example, memory 118 stores firmware executed by processing device 116 to select and apply the read voltages.

Memory controller 120 can use bias circuitry 124 to generate voltages for applying read and other voltages (e.g., initial read and read retry). Bias circuitry 124 can also generate voltages for applying write voltages to data cells 110, and/or the pattern cells as part of programming operations. Bias circuitry 124 may be used to generate read voltages for read operations performed on memory array 102 (e.g., in response to a read command from host device 126).

Sensing circuitry 122 can be used to sense a state of each memory cell in memory array 102. In one example, sensing circuitry 122 includes sense amplifiers used to detect a current caused by applying various voltages to memory cells in memory array 102. In one example, bias circuitry 124 applies a read voltage to data cells 110 or pattern cells. Sensing circuitry 122 senses a current associated with each of the data cells 110 or pattern cells caused by applying the read voltage.

In one example, if sensing circuitry 122 determines that the current for a memory cell is greater than a fixed threshold (e.g., a predetermined level of current), then memory controller 120 determines that the memory cell has switched (e.g., snapped).

In one embodiment, memory controller 120 receives a write command from host device 126. The write command is accompanied by data (e.g., user data of a host device 126) to be written to memory array 102. In response to receiving the write command, controller 120 initiates a programming operation.

In one embodiment, controller 120 uses counters to count the number of data or pattern cells that snap as a read voltage is applied. Data stored in the counters can be used as part of an evaluation when determining a read voltage to apply. This stored data can optionally be used in combination with error results from ECC of read data when selecting the read voltage (e.g., a read retry voltage).

In one example, controller 120 may use write voltages (e.g., write pulses) to write a logic state to a memory cell, such as data cell 110 or a pattern cell during a write or programming operation. The write pulses may be applied by providing a first voltage to a bitline and providing a second voltage to a wordline to select the memory cell. Circuits coupled to access lines to which memory cells may be coupled may be used to provide the write voltages (e.g., access line drivers included in decoder circuits). The circuits may be controlled by internal control signals provided by a control logic (e.g., controller 120). The resulting voltage applied to the memory cell is the difference between the first and second voltages. The write pulses may be the same duration as read pulses in some embodiments. In some embodiments the duration is 10-50 ns. In some embodiments, the duration is 1-100 ns. In some embodiments, the duration is 1 ns to 1 microsecond.

In one example, the polarity of the read or write pulses may be either a first polarity or a second polarity. For example, a write pulse may apply a voltage to a memory cell in a first polarity (e.g., bitline at 6 V and wordline at 0 V).

In one example, circuits coupled to access lines to which memory cells may be coupled are used to provide read pulses (e.g., access line drivers included in decoder circuits). The circuits may be controlled by internal control signals provided by a control logic (e.g., controller 120). A read voltage or pulse may be a voltage applied to a memory cell for a period of time (e.g., 10-50 ns, 1-100 ns, 1 ns to 1 microsecond). In some embodiments, the read pulse may be a square pulse. In some embodiments, the read pulse may be a ramp, that is, a linearly increasing voltage may be applied across the memory cell.

In one example, after being accessed (e.g., selected), a memory cell may be read, or sensed, by a sense component (e.g., sensing circuitry 122) to determine the stored state of the memory cell. For example, a voltage may be applied to the memory cell (using a wordline and bitline) and the presence of a resulting current may depend on the applied voltage and the threshold voltage of the memory cell. In some cases, more than one voltage may be applied. Additionally, if an applied voltage does not result in current flow, other voltages may be applied until a current is detected by the sense component. By assessing the voltage that resulted in current flow, the stored logic state of the memory cell may be determined. In some cases, the voltage may be ramped up in magnitude until a current flow is detected (e.g., a memory cell turns on, switches on, conducts current, or becomes activated). In other cases, predetermined voltages may be applied sequentially until a current is detected. Likewise, a current may be applied to a memory cell, and the magnitude of the voltage to create the current may depend on the electrical resistance or the threshold voltage of the memory cell.

In some cases, the memory cell (e.g., a PCM cell) includes a material that changes its crystallographic configuration (e.g., between a crystalline phase and an amorphous phase), which in turn, determines a threshold voltage of the memory cell to store information. In other cases, the memory cell includes a material that remains in a crystallographic configuration (e.g., an amorphous phase) that may exhibit variable threshold voltages to store information.

The sense component may include various transistors or amplifiers in order to detect and amplify a difference in the signals. The detected logic state of the memory cell may then be output through a column decoder as output. In some cases, the sense component may be part of a column decoder or a row decoder.

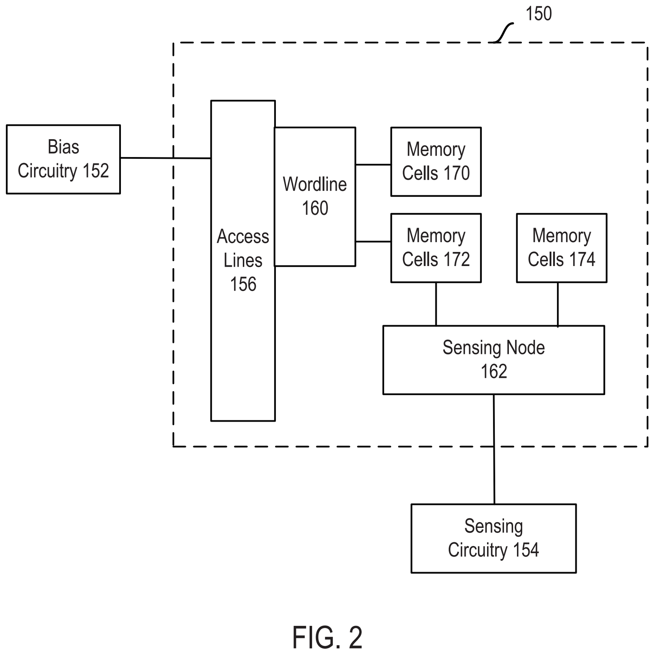

**FIG. 2** shows a memory array 150 having memory cells accessed using a common wordline 160, in accordance with some embodiments. For example, memory cells 170, 172 are sequentially accessed using the same common wordline 160. In one example, memory cells 170 are accessed using a first set of digit lines (not shown) for a first read operation, and then memory cells 172 are accessed using a second set of digit lines (not shown) for a second read operation that immediately follows the first read operation.

Memory cells 170, 172 are an example of data cells 110. Bias circuitry 152 biases access lines 156 to access various memory cells in memory array 150. For example, access lines 156 include wordlines such as wordline 160 and digit lines (not shown). Bias circuitry 152 can be similar to bias circuitry 124.

In one embodiment, during a read operation, memory cells 172 and 174 are sequentially accessed using access lines 156. Sensing circuitry 154 senses a state of memory cells 172 for a first read operation, and a state of memory cells 174 for a second read operation. Sensing node 162 is coupled to each of memory cells 172 and 174. Sensing circuitry 154 senses a state of sensing node 162 when reading memory cells 172 or 174. Sensing circuitry 154 can be similar to sensing circuitry 122.

In one embodiment, bias circuitry 152 applies voltages when performing read and/or write operations. A controller (not shown) (e.g., controller 120) receives a command associated with first and second addresses, wherein the first address corresponds to first memory cells 170 of the memory array 150, and the second address corresponds to second memory cells 172 of the memory array 150.

The controller determines (e.g., using address map 104) that the first and second memory cells are accessed using at least one common node (e.g., wordline 160). In response to receiving the command, bias circuitry 152 biases at least one access line 156 used to access the first memory cells 170 to an initial state in preparation for reading or writing the first memory cells 170.

After biasing the access line to the initial state, the controller reads or writes the first memory cells 170. After reading or writing the first memory cells 170, bias circuitry 152 biases the access line to the initial state in preparation for reading or writing the second memory cells 172. Then, the controller reads or writes the second memory cells 172. In one example, the read data is sent to host device 126.

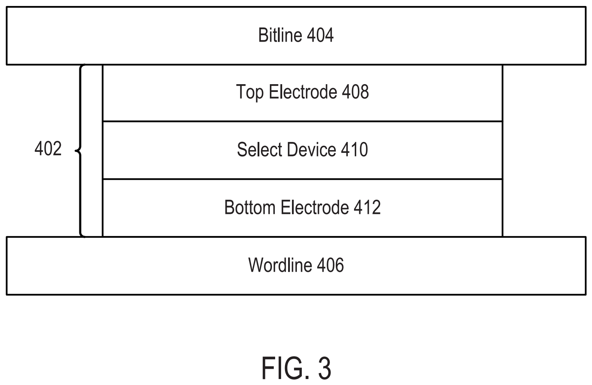

**FIG. 3** shows an example of a memory cell 402 that includes a select device, in accordance with some embodiments. In one example, select device 410 includes a chalcogenide. Memory cell 402 is an example of data cells 110.

Top electrode 408 conductively connects select device 410 to bitline 404, and bottom electrode 412 conductively connects select device 410 to wordline 406. In one example, electrodes 408, 412 are formed of a carbon material.

In one example, select device 410 includes a chalcogenide (e.g., chalcogenide material and/or chalcogenide alloy). Threshold voltage properties of the select device may be based on the voltage polarities applied to the memory cell.

In one example, a logic state may be written to memory cell 402, which may correspond to one or more bits of data. A logic state may be read from or written to the memory cell by applying voltages of different polarities at different voltage and/or current magnitudes. The reading and writing protocols may take advantage of different threshold voltages of the select device that result from the different polarities. In other words, when the memory cell is a self-selecting memory cell implemented using a selector/memory device, the select device 410 may be used as both a selecting element and a storage element of the cell 402.

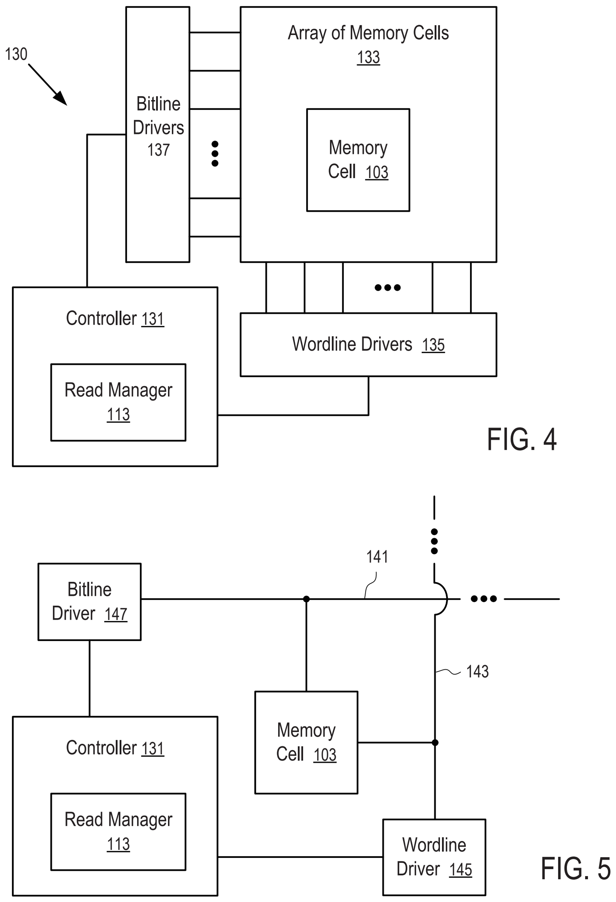

**FIG. 4** shows a memory device 130 configured with a read manager 113 to access memory cells in a memory array, according to one embodiment. Memory device 130 is an example of memory device 101. In **FIG. 4**, the memory device 130 includes an array 133 of memory cells, such as a memory cell 103. Memory cell 103 is an example of data cell 110.

In one example, an array 133 can be referred to as a tile; and a memory device (e.g., 130) can have one or more tiles. Different tiles can be operated in parallel in a memory device (e.g., 130).

For example, the memory device 130 illustrated in **FIG. 4** can have a cross-point memory having at least the array 133 of memory cells (e.g., 103). In another example, the memory device 130 illustrated in **FIG. 4** can have a 3D vertical architecture having at least the array 133 of memory cells (e.g., 103).

In some implementations, the cross-point memory uses a memory cell 103 that has an element (e.g., a sole element) acting both as a selector device and a memory device. For example, the memory cell 103 can use a single piece of alloy with variable threshold capability. The read/write operations of such a memory cell 103 can be based on thresholding the memory cell 103 while inhibiting other cells in sub-threshold bias, in a way similar to the read/write operations for a memory cell having a first element acting as a selector device and a second element acting as a phase-change memory device that are stacked together as a column. A selector device usable to store information can be referred to as a selector/memory device.

The memory device 130 of **FIG. 4** includes a controller 131 that operates bitline drivers 137 and wordline drivers 135 to access the individual memory cells (e.g., 103) in the array 133.

For example, each memory cell (e.g., 103) in the array 133 can be accessed via voltages driven by a pair of a bitline driver 147 and a wordline driver 145, as illustrated in **FIG. 5****.**

The controller 131 includes a read manager 113 configured to decode user data that is been stored using two levels of coding (e.g., as described above). In one example, the user data is stored in ternary cells 105.

In one embodiment, read manager 113 also determines one or more read voltages for reading data cells based on data obtained from applying voltages to patterns of pattern cells. The read manager 113 can be implemented, for example, via logic circuits and/or microcode/instructions. For example, during a read retry, the read manager 113 uses a read voltage having a magnitude larger than a read voltage previously used to read the memory cell (e.g., 103). The increase in the read voltage can be based on reading pattern cells (e.g., counting snaps of pattern cells). The read voltage with the increased magnitude applied to the memory cell (e.g., 103) can be sufficient to obtain the error free data from the memory cell (e.g., 103).

**FIG. 5** shows a memory cell 103 with a bitline driver 147 and a wordline driver 145 configured to apply voltages (e.g., ramps) according to one embodiment. For example, the memory cell 103 can be a typical memory cell 103 in the memory cell array 133 of **FIG. 4****.**

The bitline driver 147 and the wordline driver 145 of **FIG. 5** are controlled by the read manager 113 of the controller 131 to selectively apply one or more voltages to the memory cell 103. The bitline driver 147 and the wordline driver 145 can apply voltages of different polarities on the memory cell 103.

For example, in applying one polarity of voltage (e.g., positive polarity), the bitline driver 147 drives a positive voltage relative to the ground on a bitline 141 connected to a row of memory cells in the array 133; and the wordline driver 145 drives a negative voltage relative to the ground on a wordline 143 connected to a column of memory cells in the array 133.

In applying the opposite polarity of voltage (e.g., negative polarity), the bitline driver 147 drives a negative voltage on the bitline 141; and the wordline driver 145 drives a positive voltage on the wordline 143.

The memory cell 103 is in both the row connected to the bitline 141 and the column connected to the wordline 143. Thus, the memory cell 103 is subjected to the voltage difference between the voltage driven by the bitline driver 147 on the bitline 141 and the voltage driven by the wordline driver 145 on the wordline 143.

In general, when the voltage driven by the bitline driver 147 is higher than the voltage driven by the wordline driver 145, the memory cell 103 is subjected to a voltage in one polarity (e.g., positive polarity); and when the voltage driven by the bitline driver 147 is lower than the voltage driven by the wordline driver 145, the memory cell 103 is subjected to a voltage in the opposite polarity (e.g., negative polarity).

In some implementations, the memory cell 103 is a self-selecting memory cell implemented using a selector/memory device. The selector/memory device has a chalcogenide (e.g., chalcogenide material and/or chalcogenide alloy). For example, the chalcogenide material can include a chalcogenide glass such as, for example, an alloy of selenium (Se), tellurium (Te), arsenic (As), antimony (Sb), carbon (C), germanium (Ge), and silicon (Si). A chalcogenide material can primarily have selenium (Se), arsenic (As), and germanium (Ge) and be referred to as SAG-alloy. SAG-alloy can include silicon (Si) and be referred to as SiSAG-alloy. In some embodiments, the chalcogenide glass can include additional elements such as hydrogen (H), oxygen (O), nitrogen (N), chlorine (CI), or fluorine (F), each in atomic or molecular forms.

The selector/memory device has a top side and a bottom side. A top electrode is formed on the top side of the selector/memory device for connecting to a bitline 141; and a bottom electrode is formed on the bottom side of the selector/memory device for connecting to a wordline 143. For example, the top and bottom electrodes can be formed of a carbon material. For example, a chalcogenide material of the memory cell 103 can take the form of a crystalline atomic configuration or an amorphous atomic configuration. The threshold voltage of the memory cell 103 can be dependent on the ratio of the material in the crystalline configuration and the material of the amorphous configuration in the memory cell 103. The ratio can change under various conditions (e.g., having currents of different magnitudes and directions going through the memory cell 103).

A self-selecting memory cell 103, having a selector/memory device, can be programmed to have a threshold voltage window. The threshold voltage window can be created by applying programming pulses with opposite polarity to the selector/memory device. For example, the memory cell 103 can be biased to have a positive voltage difference between two sides of the selector/memory device and alternatively, or to have a negative voltage difference between the same two sides of the selector/memory device. When the positive voltage difference is considered in positive polarity, the negative voltage difference is considered in negative polarity that is opposite to the positive polarity. Reading can be performed with a given/fixed polarity. When programmed, the memory cell has a low threshold (e.g., lower than the cell that has been reset, or a cell that has been programmed to have a high threshold), such that during a read operation, the read voltage can cause a programmed cell to snap and thus become conductive while a reset cell remains non-conductive.

For example, to program the voltage threshold of the memory cell 103, the bitline driver 147 and the wordline driver 145 can drive a pulse of voltage onto the memory cell 103 in one polarity (e.g., positive polarity) to snap the memory cell 103 such that the memory cell 103 is in a conductive state. While the memory cell 103 is conductive, the bitline driver 147 and the wordline driver 145 continue driving the programming pulse to change the threshold voltage of the memory cell 103 towards a voltage region that represents the data or bit value(s) to be stored in the memory cell 103.

In one embodiment, the controller 131 can be configured in an integrated circuit having a plurality of decks of memory cells. Each deck can be sandwiched between a layer of bitlines, a layer of wordlines; and the memory cells in the deck can be arranged in an array 133. A deck can have one or more arrays or tiles. Adjacent decks of memory cells may share a layer of bitlines (e.g., 141) or a layer of wordlines (e.g., 143). Bitlines are arranged to run in parallel in their layer in one direction; and the wordlines are arranged to run in parallel in their layer in another direction orthogonal to the direction of the bitlines. Each of the bitlines is connected to a row of memory cells in the array; and each of the wordlines is connected to a column of memory cells in the array. Bitline drivers 137 are connected to bitlines in the decks; and wordline drivers 135 are connected to wordlines in the decks. Thus, a typical memory cell 103 is connected to a bitline driver 147 and a wordline driver 145.

In one embodiment, the threshold voltage of a typical memory cell 103 is configured to be sufficiently high such that when only one of its bitline driver 147 and wordline driver 145 drives a voltage in either polarity while the other voltage driver holds the respective line to the ground, the magnitude of the voltage applied across the memory cell 103 is insufficient to cause the memory cell 103 to become conductive. Thus, addressing the memory cell 103 can be performed via both of its bitline driver 147 and wordline driver 145 driving a voltage in opposite polarity relative to the ground for operating/selecting the memory cell 103. Other memory cells connected to the same wordline driver 145 can be de-selected by their respective bitline drivers holding the respective bitlines to the ground; and other memory cells connected to the same bitline driver can be de-selected by their respective wordline drives holding the respective wordlines to the ground.

A group of memory cells (e.g., 103) connected to a common wordline driver 145 can be selected for parallel operation by their respective bitline drivers (e.g., 147) driving up the magnitude of voltages in one polarity while the wordline driver 145 is also driving up the magnitude of a voltage in the opposite polarity. Similarly, a group of memory cells connected to a common bitline driver 147 can be selected for parallel operation by their respective wordline drivers (e.g., 145) driving voltages in one polarity while the bitline driver 147 is also driving a voltage in the opposite polarity.

At least some examples are disclosed herein in reference to a cross-point memory having self-selecting memory cells. Other types of memory cells and/or memory can also be used. For example, memory cells each having a selector device and a phase-change memory device and/or flash memory cells can also be used in at least some embodiments. Additionally or alternatively, the memory can have a different architecture, such as a 3D vertical architecture.

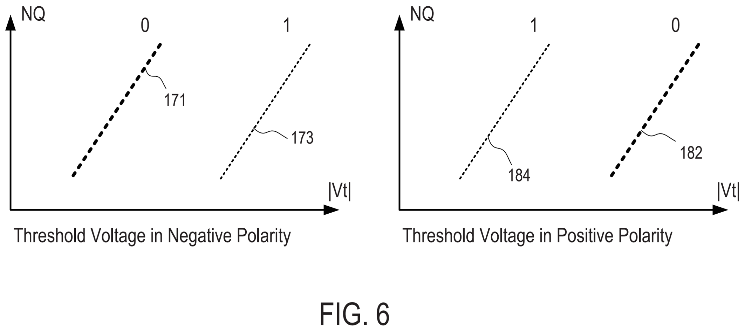

**FIG. 6** shows an exemplary normal quantile (NQ) plot representing the statistical distributions (e.g., 171, 173, 182, 184) of threshold voltages of memory cells. In one example, the memory cells are data cells 110. When a probability distribution (e.g., 171) of threshold voltages programmed in a region is a normal distribution (also known as Gaussian distribution), its normal quantile (NQ) plot is seen as aligned on a straight line (e.g., distribution 171).

A self-selecting memory cell (e.g., 103) can have a threshold voltage in negative polarity and a threshold voltage in positive polarity. When a voltage applied on the memory cell 103 in either polarity is increased in magnitude up to its threshold voltage in the corresponding polarity, the memory cell (e.g., 103) switches (e.g., snaps) from a non-conductive state to a conductive state.

The threshold voltage of a memory cell 103 in negative polarity and the threshold voltage of the memory cell 103 in positive polarity can have different magnitudes. Memory cells programmed to have large magnitudes in threshold voltages in positive polarity can have small magnitudes in threshold voltages in negative polarity; and memory cells programmed to have small magnitudes in threshold voltages in positive polarity can have large magnitudes in threshold voltages in negative polarity.

For example, a memory cell can be programmed to have a small magnitude in threshold voltage according to distribution 184 in the positive polarity to represent a value (e.g., one); and as a result, its threshold voltage has a large magnitude according to distribution 173 in the negative polarity to represent the same value (e.g., one). Alternatively, the memory cell can be programmed to have a large magnitude in threshold voltage according to distribution 182 in the positive polarity to represent another value (e.g., zero); and as a result, its threshold voltage has a smaller magnitude according to distribution 171 in the negative polarity to represent the same value (e.g., zero).

Thus, to determine whether a memory cell 103 is storing the one value (e.g., one) or the other value (e.g., zero), the read manager 113 can read the memory cell 103 in either the positive polarity or the negative polarity. If the threshold voltage of the memory cell 103 has a large magnitude according to distribution 182 in the positive polarity, it stores the other value (e.g., zero); otherwise, it stores the one value (e.g., one). Similarly, if the threshold voltage of the memory cell 103 has a large magnitude according to distribution 173 in the negative polarity, it stores the one value (e.g., one); otherwise, it stores the other value (e.g., zero).

The threshold voltage distributions of memory cells may change after a read. For example, in the positive polarity, a read can cause the high magnitude distribution 182 to shift downward, and/or the low magnitude distribution 184 to shift downward.

Similarly, in negative polarity, the read can cause the high magnitude distribution 173 to shift downward, and/or the low magnitude distribution 171 to shift downward.

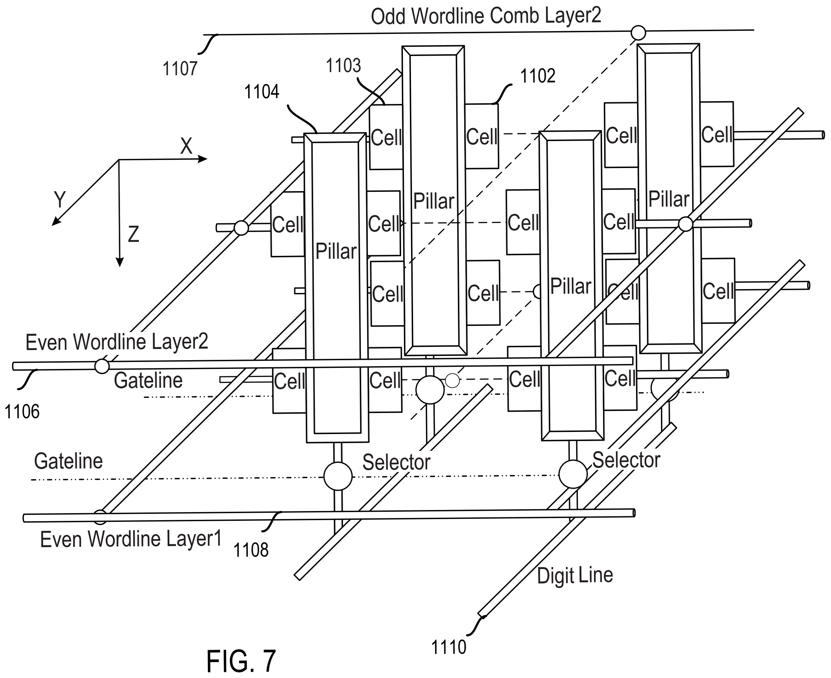

**FIG. 7** shows an exemplary three-dimensional memory array structure having wordlines configured in a comb structure, in accordance with some embodiments. The memory array and memory cells described herein are not limited to use in a planar architecture (e.g., with cells at crossing of wordlines (WLs) and bitlines (BLs) on different levels). Instead, the approach also can be used for vertical architectures (e.g., vertical BL pillars crossing horizontal WL planes).

An example of a vertical architecture that can be used with embodiments described in this disclosure is illustrated in **FIG. 7****.** As illustrated, a memory array includes memory cells 1102, 1103. Each memory cell 1102, 1103 can be selected using a wordline (e.g., 1106, 1107, or 1108) and a digit line (e.g., 1110). Memory cells 1102, 1103 are an example of data cells 110 of **FIG. 1****.**

In one embodiment, each wordline extends in one of a plurality of horizontal planes of wordlines 1106, 1107, 1108 stacked vertically above a semiconductor substrate (not shown). Each digit line or bitline (e.g., 1110) includes a pillar 1104. Each pillar 1104 extends vertically away from the semiconductor substrate. Each memory cell 1102, 1103 is located on sides of one of pillars 1104.

In one embodiment, the memory array has a vertical array architecture comprising vertical bitlines (e.g., vertical pillars 1104) or digit lines intersecting a plurality of horizontal decks of wordlines (e.g., even wordlines 1106 and odd wordlines 1107). Each deck is configured as two interdigitated wordline combs so that each bitline or digit line forms two cells 1102, 1103 at each of the decks. In one example, even wordlines 1106 are interdigitated with odd wordlines 1107 in a comb structure as illustrated.

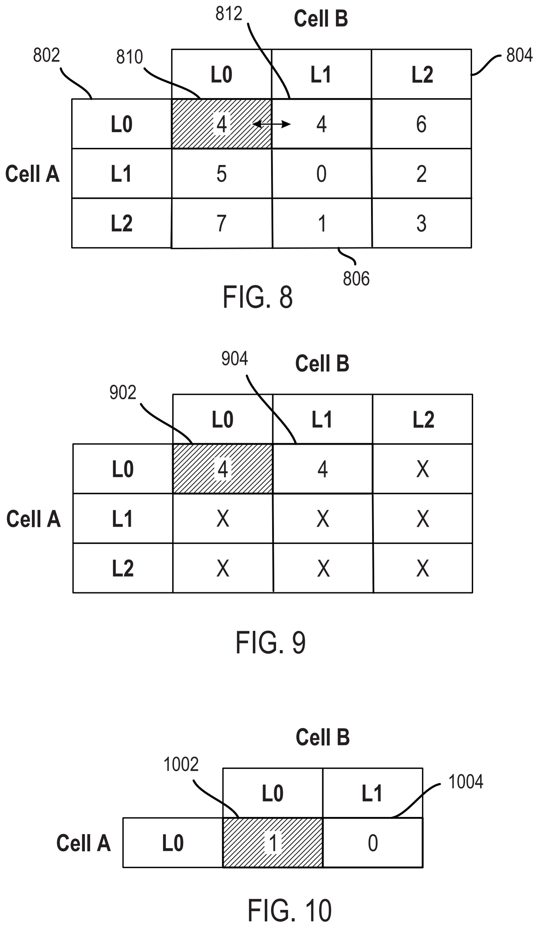

**FIG. 8** shows a coding table for storing data using a pair of ternary cells (e.g., Cell A and Cell B), in accordance with some embodiments. Cell A stores data in one of three data states or levels 802. Cell B stores data in one of three data states or levels 804. Cell A and Cell B are examples of ternary cells 105. In one example, controller 120 programs each of the pair of memory cells to one of these levels.

The pair of memory cells is used to store a three-bit combination. Each three bit combination corresponds to one of eight decimal values 806 (e.g., 0, 1, 2, 3, 4, 5, 6, 7). For example, the decimal value 2 is stored by a level combination of L1/L2.

One of the decimal values is selected as a special value for implementing two-level coding. In one example, the special value is selected as 4. Level combination 810 is a redundant level combination. The coding table represents a single-level coding for values other than the special value.

For the special value, either of level combination 810 or level combination 812 can be used to store this data. For example, an additional bit can be stored for which its value is represented by the one of level combination 810 or 812 that is programmed into the memory cells. Thus, when storing user data corresponding to the special value, a total of four bits (e.g., three bits to represent the value of 4 plus an additional bit) can be stored instead of a total of three bits as for the other values of the user data.

In other embodiments, a different decimal value (e.g., 3 or 7) can be selected as the special value. Also, coding tables can use level combinations from more than two memory cells. Additionally and/or alternatively, the memory cells can use more than three levels.

In one example, a coding/decoding table uses 2 cells and 3 levels (9 combinations) to code 3 bits (2³ = 8 different combinations). The redundant level combination 810 is not used for storing these eight different combinations (there is no corresponding coding combination). However, a decoding value corresponding to the special value is associated with this redundant level combination. It is noted that choosing the base value (e.g., 4) equal to the neighbor cell value can reduce errors in the case of error-prone technology. For example, a drift of the cell content may preserve the 3 base bits.

In one example, an additional bit's combination value is selected as L0L0 or LOL1 during encoding/decoding by coding circuitry 112.

In one embodiment, data balancing of codewords in user data can be done to ensure fixed-number bits distributions.

**FIG. 9** shows a coding table for storing data using one level of coding, in accordance with some embodiments. Cell A and Cell B are programmed as illustrated to various level combinations to store a decimal value corresponding to a three-bit combination. These decimal values are generally indicated by the letter "X" in **FIG. 9****.** Thus, in general, a three-bit combination is stored for each position in the coding table.

In the case of the special value 4, Cell A is programmed to level L0. Cell B is programmed to level L0 at coding table position 902 or level L1 at coding table position 904. At this first level of coding, programming to either of level L0 or L1 represents storage of the special value 4 from user data.

In other embodiments, coding table positions can be arbitrarily varied as desired. It is not required that the special value position 904 and the redundant level combination position 902 be adjacent in the table. In one example, the special value (position 902) may also be in a different position (not LOLO).

In one example, if controller 120 identifies a special value 4 in user data, then controller 120 can selectively determine whether to store an additional bit associated with the special value 4.

**FIG. 10** shows a coding table for storing data that corresponds to a defined or special value using two levels of coding, in accordance with some embodiments. Specifically, the coding table shows coding for an additional bit that is stored in association with a special value that has been identified in the data to be stored. For example, the coding table provides a coding for an additional bit that corresponds to special value 4 of position 902 or 904. The stored binary value of the additional bit is indicated by the programming of Cell B to either level L0 at position 1002 or level L1 at position 1004. Thus, four bits can be stored that correspond to the special value. The value of the three-bit combination is represented by the first level of coding as shown in **FIG. 9**. The value of the fourth bit is represented by the second level of coding as shown in **FIG. 10****.**

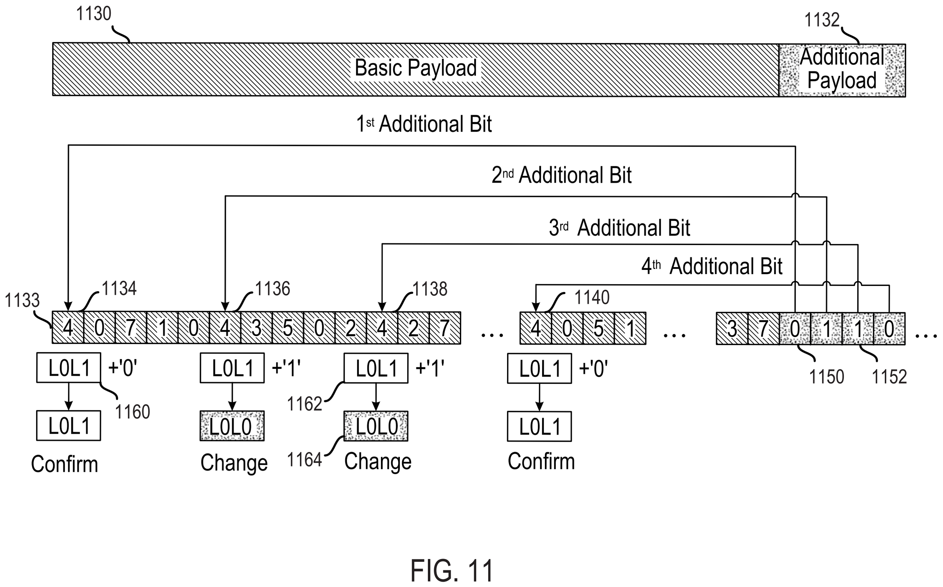

**FIG. 11** shows coding for a data flow to store additional bits using two levels of coding, in accordance with some embodiments. The data flow includes a basic payload 1130 to be stored in a memory array. In one example, basic payload 1130 is user data received from host device 126.

The data flow includes various values 1133. Positions of the special value in the data flow are identified (e.g., by a controller). For example, positions 1134, 1136, 1138, 1140 correspond to special value 4. The controller can determine to store an additional bit for each of these positions. The additional bit is stored by the coding of the second level combinations used for a pair of ternary cells at each position.

For example, additional bit 1150 has a value of zero. A controller confirms using level combination 1160 for programming a pair of ternary cells.

For example, additional bit 1152 has a value of one. The controller confirms changing level combination 1162 to level combination 1164 to represent storage of the value of one.

The foregoing approach can be used for each additional bit to be stored in association with special values identified in the basic payload 1130. By this approach, additional payload 1132 can be stored in addition to the basic payload 1130.

In one example, all the positions of the special values "4" in User Data are identified. An additional bit is associated to each special value. If the additional bit is "0", the original position is kept: "4" & 0 → LOL**1**. If the additional bit is "1", the alternative position is selected: "4" & 1 → LOL**0**.

In one embodiment, the quantity of data in additional payload 1132 depends on the quantity of the special values in the user data. In some cases, a controller can guarantee a number of those special values are present inside the user data (e.g., a page). Otherwise, the additional bits may (e.g., randomly) vary from 0 to 33% (in the case of 3/2 coding).

The quantity or number of special values in user data can be adjusted using various techniques. In one example, balancing of data can be used. In one example, a perfect balancing of the special values guarantees a fixed and predetermined quantity of additional payload 1132.

Alternatively, a controller can scan coding values and select a distribution that can guarantee the target number of special values.

In some embodiments, a controller can also use unbalancing of user data to change a distribution (e.g., for some memory technologies, it may be desirable to reduce a number of cells in critical level values).

In one example, because the quantity of additional payload data depends on the quantity of the special values (e.g., 4), a perfect balanced message allows a controller to predict the additional payload from the beginning.

In one embodiment, if the additional payload is variable, a controller can manage this variability.

In some cases, a fixed additional payload can be easier to implement and be more reliable. A fixed weight codeword it is a more general case of a balanced codeword. For example, consider a three-state technology having states A, B, C. A balanced codeword has 33% of its bits in state A, 33% in state B, and 33% in state C. A fixed weight codeword could have 40% of bits in state A, 40% in state B, and 20% in state C. In some cases, this approach can be convenient in terms of extra bits, and it also allows a controller to know the additional payload from the beginning without further extra bits being needed.

In one example, the number of ones and zeros in a codeword is unknown. The controller can add combinations of ones and/or zeros to even out a distribution of each in the codeword. In one example, states of the bits in a codeword can be flipped. This flipping can be tracked using an extra bit.

In one embodiment, a balancing algorithm used by a controller can adjust user data so that the data to be stored has an increased quantity or number of special values. This can permit making better use of the additional payload.

In some cases, user data may include all zeros or all ones in a codeword. A memory device (e.g., a NAND device) can implement scrambling of codewords to avoid having all zeros or all ones in the codewords.

In one embodiment, the controller implements an algorithm to guarantee or ensure a statistical proportion of special values and codewords. This is in contrast to using a fixed approach.

In some embodiments, a controller can define the special value so that a particular distribution of data states of the memory cells is used. For example, the proportion of a particular data state can be increased by defining the special value. The special value can be selected dynamically as the controller is operating. For example, after scanning the user data, the controller can select the special value to use for coding that data.

In one embodiment, a coding scheme may map multiple data bits (e.g., three data bits) to two ternary cells (e.g., denoted cell i and cell j). For ease of reference, the three data bits are denoted x, y, and z. The x-bit may be in the most significant bit position, the y-bit may be in the intermediate bit position, and the z-bit may be in the least significant bit position. The use of the coding scheme may allow a memory device to reduce (relative to State B and State C) the quantity of ternary cells in State A. The use of the coding scheme may allow a memory device to reduce (relative to State A and State C) the quantity of ternary cells in State B. And use of the coding scheme may allow a memory device to reduce (relative to State A and State B) the quantity of ternary cells in State C.

The memory device may receive a sequence of data bits for storage in an array of cells (e.g., an array of ternary cells). The memory device may divide (e.g., logically or physically) the data bits into combinations of (x, y, z) bits for mapping to respective pairs of ternary cells according to a coding scheme such as the coding table of **FIG.** 8. Put another way, the memory device may assign the data bits to groups of x-bits, y-bits, and z-bits. Each combination of (x, y, z) bits may be mapped to a corresponding pair of ternary cell states based on the coding scheme. For instance, if (x0, y0, z0)=(1, 1, 1), the combination of (x0, y0, z0) may be mapped to State A (cell j) and State B (cell i).

In one embodiment, a memory device can divide a sequence of data into two sets of data bits. In such case, the sequence of data may be divided into a first set of data bits made up of x-bits and a second set of data bits made up of y-bits and z-bits.

After dividing the sequence of data into sets of bits, the memory device may generate a codeword from the set of x-bits. For example, the memory device may (e.g., via ECC encoding) generate parity bits (denoted p) based on the set of x-bits and may combine the parity bits and the set of x-bits into a codeword (e.g., codeword(x)).

After generating codeword(x), the memory device may balance codeword(x) in the binary domain to reach a target distribution of ternary cells in State B (which is linked to the x-bit). For example, the memory device may invert (e.g., using Knuth or quantized-Knuth balancing) one or more of the x-bits in codeword(x) to reach a target distribution of logic values (e.g., 50% 1s, 50% 0s) associated with an overall target distribution of State B for the sequence of data (e.g., 25% State B). After the balancing process, codeword(x) may include one or more inverted x-bits (denoted x') and/or one or more inverted parity bits (denoted p').

In one embodiment, a fixed weight codeword may refer to a codeword that is associated with a fixed distribution of programmable states. Put another way, a fixed weight codeword may be a codeword that, when stored in ternary cells, results in a fixed (e.g., set) quantity of ternary cells in each state. The weight of a codeword may refer to the distribution of programmable states associated with the codeword. To appropriately weight a codeword, which may be referred to as balancing the codeword, a memory device may map the bits in the codeword to packets and employ a balancing process in which the packets are inverted (e.g., one at a time) until a determined weight has been achieved (e.g., until the codeword is balanced). To ensure that the original logic values of a balanced codeword can be accurately recovered during a subsequent read operation, the memory device may explicitly or implicitly store balancing information bits that indicate which packets of the data were inverted during the balancing process. During a read operation, the memory device may reference the balancing information bits so that the memory device can un-invert the proper packets of the bits (e.g., those inverted during the balancing process) before data bits from the codeword are returned to a requesting device.

Balancing codewords before storage may allow the memory device (e.g., using controller 120) to implement various techniques that improve operation of the memory device. The memory device may receive a set of data bits for storage in an array of ternary cells. The memory device may divide (e.g., logically or physically) the data bits into subsets of (x, y, z) bits for storage in respective pairs of ternary cells according to a coding scheme (e.g., coding tables of **FIGs. 9-10**). Put another way, the memory device may assign the data bits to groups of x bits, y bits, and z bits. If the quantity of x bits is different than the quantity of y bits (or z bits) (e.g., a discrepancy that may allow the memory device to minimize the quantity of ternary cells used to the store the codewords), the memory device may divide the data bits into some subsets of (x, y, z) bits and some subsets of (y, z) bits (e.g., if there are more y bits and z bits than x bits) or the memory device may divide the data bits into some subsets of (x, y, z) bits and some subsets of (x) bits (e.g., if there are more x bits than y bits and z bits).

The memory device may form a first sub-message that includes the x bits of the subsets and may form a second sub-message that includes the y bits and z bits of the subsets. Forming a sub-message may refer to communicating the data bits of the sub-message to an ECC encoder for ECC encoding.

The memory device may generate a first codeword (e.g., codeword(x)) from the first sub-message and may generate a second codeword (e.g., codeword(y, z)) from the second sub-message. The memory device may generate codeword(x) by encoding the first sub-message with an ECC code (which may include applying an ECC code to the x bits of the first sub-message). Codeword(x) may include the x bits from the subsets and parity bits (denoted (p(x)) that are based on the x bits.

The memory device may generate codeword(y, z) by encoding the second sub-message with the ECC code (which may include applying the ECC code to the (y, z) bits of the second sub-message). Codeword(y) may include the (y, z) bits and parity bits (denoted (p(y, z)) that are based on the (y, z) bits.

In one embodiment, a memory device may perform a balancing process in which the memory device balances codeword(x) and codeword(y, z). The memory device may balance codeword(x) by inverting one or more packets of codeword(x). Inverting a packet may refer to inverting the bits of the packet (e.g., changing logic zeros to logic ones, and vice versa). The memory device may balance codeword(x) based on the coding scheme and a target distribution for codeword(x). After the inversion, codeword(x) may include one or more x bits and parity bits that have been inverted. The memory device may invert the packets of codeword(x) so that the target distribution of states is reached. For example, the memory device may invert the packets of codeword(x) so that 50% of the bits in codeword(x) are logic ones. So, after the inversion process, 50% of the states associated with codeword(x) may be State A, 25% of the states may be State B, and 25% of the states may be State C (due to the coding scheme). Thus, the memory device may invert a portion of codeword(x) so that codeword(x) has a fixed weight.

The memory device may balance codeword(y, z) by inverting one or more packets of codeword(y, z). The memory device may balance codeword(y, z) based on the coding scheme and a target distribution for codeword(y, z). After the inversion, codeword(y, z) may include one or more y bits, z bits, and parity bits that have been inverted. The memory device may invert the packets of codeword(y, z) so that the target distribution of states is reached. For example, the memory device may invert the packets of codeword(y, z) so that 50% of the states associated with codeword(y, z) are State B and 50% of the states are State C. Thus, the memory device may invert a portion of codeword(y, z) so that codeword(y, z) has a fixed weight.

After balancing the codewords, the memory device may store the balanced codewords in an array of ternary cells (e.g., memory array 102 of **FIG. 1**). For example, memory device may store codeword(x) and codeword(y, z) in a set of the ternary cells according to the coding scheme. Thus, in one example, 25% the ternary cells may be in State A, 37.5% of the ternary cells may be in State B, and 37.5% of the ternary cells may be in State C.

In some examples, the memory device may add one or more padding bits to the codewords to reach the target distributions. For example, if less than 50% of the states associated with codeword(x) are State A, the memory device may add an appropriate quantity of padding bits set to logic one to resolve the difference between the target quantity for State A and the actual quantity for State A. The memory device may additionally or alternatively add padding bits to codeword(y, z) to ensure that codeword(y, z) is associated with the target quantity of B states (e.g., equal to 37.5% of the total states). A codeword that has the target distribution of states may be referred to as precisely weighted and a codeword that does not have the target distribution (but that is within a threshold range of the target distribution) may be referred to as imprecisely weighted. The ability of a memory device to precisely weight a codeword using balancing alone may be related to the packet size used for the codeword, with smaller packet sizes enabling higher precision relative to larger packet sizes.

In some examples, the memory device may optimize or improve the storage process by selecting quantities of x bits, y bits, and z bits so that the quantity of ternary cells used to store the codewords is minimized or reduced. For ease of reference the quantity of x bits may be referred to as Dx (or the payload of codeword(x)) and the sum quantity of y bits and z bits may be referred to as D_{YZ} (or the payload of codeword(y, z)). Additionally, the sum quantity of parity bits of codeword (x) may be referred to a Px and the sum quantity of parity bits of codeword(y, z) may be referred to as P_{YZ}. Px and P_{YZ} may be defined by the total payload (e.g., D_{X}+D_{YZ}) for codeword(x) and codeword(y, z), the ECC protection level, or both. To reduce the quantity of ternary cells used to store the codewords, the memory device may select Dx and D_{YZ} so that the quantity of ternary cells for storing codeword(x) (referred to as Q_{X}) is equal to the quantity of ternary cells for storing codeword(y, z) (referred to as Q_{YZ}).

In one embodiment, a memory device may balance codeword(x, y, z) by inverting one or more packets of codeword(x, y, z). The memory device may balance codeword(x, y, z) based on the coding scheme and a target distribution for codeword(x, y, z). After the inversion, codeword(x, y, z) may include one or more x bits, y bits, z bits, and parity bits that have been inverted. The memory device may invert the packets of codeword(x, y, z) so that the target distribution of states is reached. For example, the memory device may invert the packets of codeword(x, y, z) so that 25% of the states associated with codeword(x) are State A, 37.5% of the states are State B, and 37.5% of the states are State C. Thus, the memory device may invert a portion of codeword(x, y, z) so that codeword(x, y, z) has a fixed weight.

After balancing codeword (x, y, z), the memory device may store the balanced codeword in the array of ternary cells. For example, memory device may store codeword(x, y, z) in a set of the ternary cells according to the coding scheme. Thus, in one example, 25% the ternary cells may be in State A, 37.5% of the ternary cells may be in State B, and 37.5% of the ternary cells may be in State C.

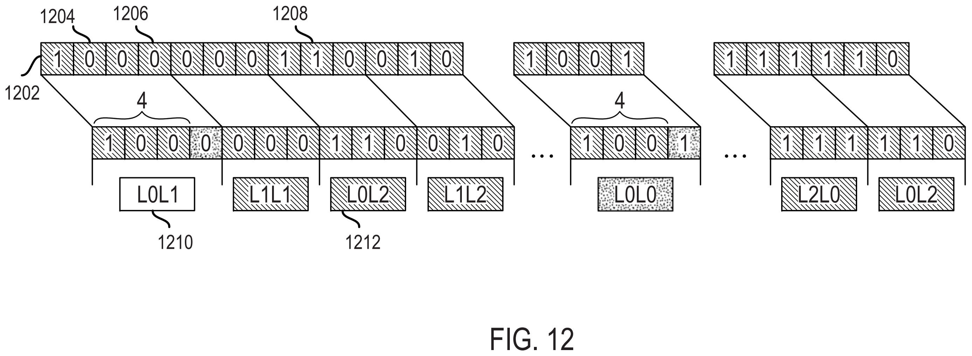

**FIG. 12** shows scanning of a data flow to identify special values for storing additional bits using two levels of coding, in accordance with some embodiments. User data flow 1202 is scanned to identify all special values in the user data. Bit combination 1204 (100) is identified as corresponding to special value 4. The controller appends additional bit 1206 (0) to bit combination 1204 and stores all four bits using level combination 1210 (L0L1). Thus, four bits are stored using two levels of coding.

Bit combination 1208 (110) does not correspond to the special value. Therefore, the controller stores a value corresponding to this bit combination based on only a first level of coding. The value is stored as level combination 1212 (LOL2).

A similar approach to the above is used for other special values identified in user data flow 1202, as illustrated.

In one example, all the positions of the special values "4" in User Data are identified. An additional bit is added to each special value. If the additional bit is "0", the original position is kept: "4" & 0 → LOL**1**. If the additional bit is "1", the alternative position is selected: "4" & 1 → L0L**0**.

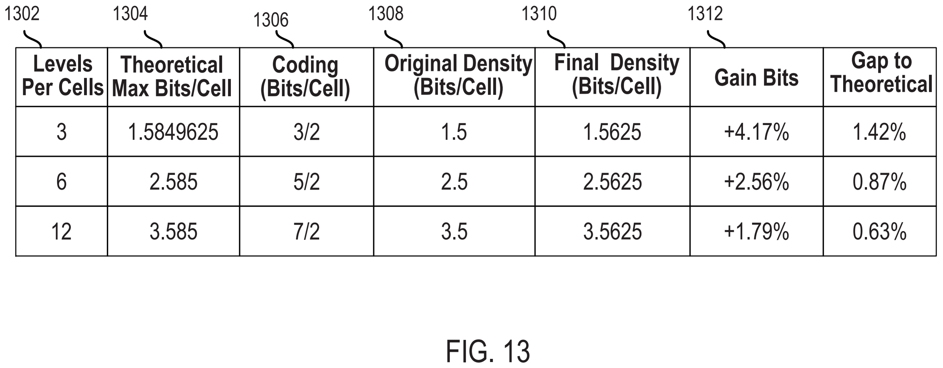

**FIG. 13** shows exemplary improvements in storage density for memory cells having various multiple levels per cell by storing additional bits using two levels of coding, in accordance with some embodiments. Column 1302 indicates a number of levels per cell used to store data. Column 1304 indicates a maximum theoretical storage density using the indicated type of memory cell.

Column 1306 indicates a number of bits stored per cell. For example, a three-bit combination is stored using two cells. Column 1308 indicates a storage density achieved using only a single level of coding. For example, storage of three-bit combinations using two ternary cells achieves a density of 1.5 bits per cell.

Column 1310 indicates a storage density achieved using two levels of coding for special values as described herein. For example, when using a pair of ternary cells and two-level coding, a density of 1.5625 bits per cell can be achieved. Column 1312 indicates the percentage increase in storage density achieved using two levels of coding for special values as compared to using only one level of coding.

In one example, storage density can be increased by adding more bits per page of data. In one example, storage density can be increased by using fewer memory cells for a given quantity of bits.

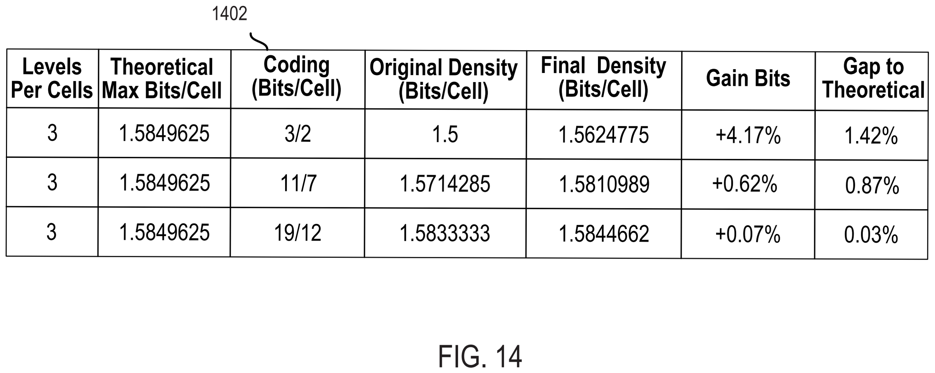

**FIG. 14** shows exemplary improvements in storage density for ternary cells by storing additional bits using two levels of coding, in accordance with some embodiments. Column 1402 indicates a number of bits stored per cell. For example, a three-bit combination is stored using two cells. For example, an 11-bit combination is stored using 7 cells. The other columns indicate similar data as for the columns of **FIG. 13** described above.

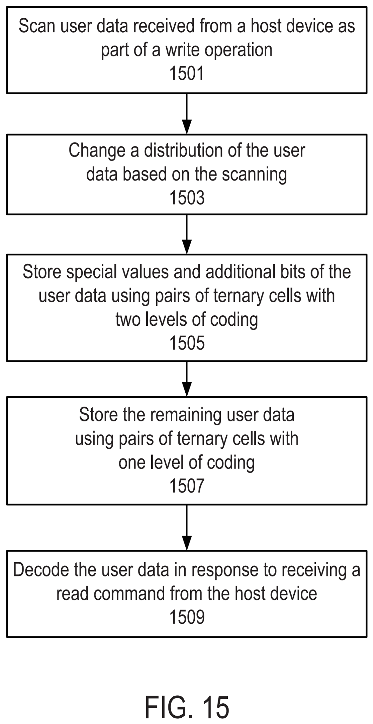

**FIG. 15** shows a method for storing user data using pairs of ternary cells, in accordance with some embodiments. For example, the method of **FIG. 15** can be implemented in the system of **FIGs. 1-2****.**

The method of **FIG. 15** can be performed by processing logic that can include hardware (e.g., processing device, circuitry, dedicated logic, programmable logic, microcode, hardware of a device, integrated circuit, etc.), software (e.g., instructions run or executed on a processing device), or a combination thereof. In some embodiments, the method of **FIG. 15** is performed at least in part by one or more processing devices (e.g., controller 120 of **FIG. 1**).

Although shown in a particular sequence or order, unless otherwise specified, the order of the processes can be modified. Thus, the illustrated embodiments should be understood only as examples, and the illustrated processes can be performed in a different order, and some processes can be performed in parallel. Additionally, one or more processes can be omitted in various embodiments. Thus, not all processes are required in every embodiment. Other process flows are possible.

At block 1501, user data received from a host device is scanned as part of a write operation. For example, the host device sends a write command to a memory device to store the user data. In one example, controller 120 receives user data from host device 126.

At block 1503, a distribution of the user data is changed based on results from the scanning. For example, a distribution of ones and zeros in the user data is changed.

At block 1505, special values and additional bits of the user data are stored using pairs of ternary cells. The special values are stored using a first level of coding, and the additional bits are stored using a second level of coding. The additional bits correspond to the special values. In one example, the additional bits are added to the special values. In one example, the additional bits are associated to the special values. In one example, the special values and additional bits are stored using the coding tables of **FIGs. 9-10****.**

At block 1507, the remaining user data that does not include the special values is stored using the pairs of ternary cells. The remaining user data stored using only the first level of coding.

At block 1509, the user data stored above is decoded in response receiving a read command from the host device. The decoding is performed using coding tables corresponding to the first and second levels of coding above used to store the user data. In one example, coding and decoding is performed by coding circuitry 112.

In some aspects, the techniques described herein relate to an apparatus including: a memory array including ternary cells (e.g., 105); and at least one controller configured to store data in the ternary cells, wherein the data corresponding to a defined value (e.g., a special value of 4) is stored using two levels of coding (e.g., coding tables of **FIGs. 9-10**), and other remaining data (e.g., values of 0, 1, 2, 3, 5, 6, 7) is stored using one level of coding (e.g., **FIG. 8**).

In some aspects, the techniques described herein relate to an apparatus, wherein the data includes bit combinations (e.g., a binary value represented by 3 bits), the bit combinations corresponding to the defined value are stored using the two levels of coding, and other remaining bit combinations are stored using the one level of coding.

In some aspects, the techniques described herein relate to an apparatus, wherein the controller (e.g., 120) is further configured to receive the data from a host device (e.g., 126) as part of a write operation requested by the host device.

In some aspects, the techniques described herein relate to an apparatus, wherein the controller is further configured to select the defined value based on a characteristic of the data. In one example, the characteristic of the data is a distribution of ones and zeros in the data.

In some aspects, the techniques described herein relate to an apparatus, wherein the data includes bit combinations, and each bit combination is stored using a pair of the ternary cells.

In some aspects, the techniques described herein relate to an apparatus, wherein a first bit combination of the data corresponds to the defined value and is stored in first and second ternary cells, and a state of each of the first and second ternary cells is programmed by the controller based on an additional bit to be stored.

In some aspects, the techniques described herein relate to an apparatus, wherein the additional bit is associated with the first bit combination.

In some aspects, the techniques described herein relate to an apparatus, wherein the controller is further configured to determine that the data includes a first bit combination representing the defined value, and in response to determining that the data includes the first bit combination, apply a second level of coding to code an additional bit.

In some aspects, the techniques described herein relate to an apparatus, wherein the first bit combination is stored using first and second ternary cells, and applying the second level of coding includes selecting a first or second state of the first ternary cell (e.g., state L0 or L1 of Cell B) of the memory array based on a value (e.g., 0 or 1) represented by the additional bit. In one embodiment, the state of the second ternary cell or even both ternary cells could be selected.

In some aspects, the techniques described herein relate to an apparatus, wherein a programmed state of the second ternary cell (e.g., state L0 of Cell A) when storing the first bit combination is the same for either of the first and second states of the first ternary cell. In one embodiment, both Cells A and B can be modified by the additional bit (it is not mandatory that only the first cell is modified by the additional bit).

In some aspects, the techniques described herein relate to an apparatus, wherein the controller is further configured to store the data using a coding table that maps multiple data bits in the data to programmable states for pairs of ternary cells (e.g., 3 data bits representing the value 7 are mapped to Cell A programmed to state L2 and Cell B programmed to state LO).

In some aspects, the techniques described herein relate to an apparatus, wherein the coding table includes combinations of the programmable states (e.g., L2/L0, L1/L1), and one of the combinations is a redundant combination (e.g., L0/L0) corresponding to the defined value.

In some aspects, the techniques described herein relate to a method including: identifying positions of special values in user data; and associating a respective additional bit to each identified position.

In some aspects, the techniques described herein relate to a method, further including storing the user data at the identified positions using a first level of coding, and storing the respective additional bits using a second level of coding.

In some aspects, the techniques described herein relate to a method, further including programming, for each additional bit, states of a respective pair of ternary cells based on a value of the additional bit.

In some aspects, the techniques described herein relate to a method, wherein each special value corresponds to a respective bit combination (e.g., 3 bits in a serial flow of data), and associating the respective additional bit includes adding the additional bit to the bit combination (e.g., add a bit 0 to bits 100 in the user data flow prior to coding the data for storing using a pair of ternary cells).

In some aspects, the techniques described herein relate to a method, further including storing each bit combination and corresponding additional bit using a pair of ternary cells.

In some aspects, the techniques described herein relate to a method, wherein the user data is a basic payload (e.g., 1130), and the additional bits are an additional payload (e.g., 1132).

In some aspects, the techniques described herein relate to a system including: at least one processing device; and at least one memory containing instructions configured to instruct the at least one processing device to: adjust a proportion of special values in data; and store, using pairs of ternary cells, each special value with a respective additional bit.

In some aspects, the techniques described herein relate to a system, wherein adjusting the proportion includes balancing codewords in the data to change a distribution of at least one programmed state of the ternary cells.

In some aspects, the techniques described herein relate to a system, wherein the processing device is further configured to: scan the data; change, based on the scanning, a distribution of the data (e.g., a number of 0s and 1s in the data); and after changing the distribution, coding the data for storage in the ternary cells.

In some aspects, the techniques described herein relate to a system, wherein adjusting the proportion includes targeting a number of special values in the data.

In some aspects, the techniques described herein relate to a system, wherein the data is a basic payload, and adjusting the proportion includes targeting a quantity of additional payload. In one example, the quantity of additional payload is a number of bits.

The disclosure includes various devices which perform the methods and implement the systems described above, including data processing systems which perform these methods, and computer-readable media containing instructions which when executed on data processing systems cause the systems to perform these methods.

The description and drawings are illustrative and are not to be construed as limiting. Numerous specific details are described to provide a thorough understanding. However, in certain instances, well-known or conventional details are not described in order to avoid obscuring the description. References to one or an embodiment in the present disclosure are not necessarily references to the same embodiment; and, such references mean at least one.

As used herein, "coupled to" or "coupled with" generally refers to a connection between components, which can be an indirect communicative connection or direct communicative connection (e.g., without intervening components), whether wired or wireless, including connections such as electrical, optical, magnetic, etc.

Reference in this specification to "one embodiment" or "an embodiment" means that a particular feature, structure, or characteristic described in connection with the embodiment is included in at least one embodiment of the disclosure. The appearances of the phrase "in one embodiment" in various places in the specification are not necessarily all referring to the same embodiment, nor are separate or alternative embodiments mutually exclusive of other embodiments. Moreover, various features are described which may be exhibited by some embodiments and not by others. Similarly, various requirements are described which may be requirements for some embodiments but not other embodiments.

In this description, various functions and/or operations may be described as being performed by or caused by software code to simplify description. However, those skilled in the art will recognize what is meant by such expressions is that the functions and/or operations result from execution of the code by one or more processing devices, such as a microprocessor, Application-Specific Integrated Circuit (ASIC), graphics processor, and/or a Field-Programmable Gate Array (FPGA). Alternatively, or in combination, the functions and operations can be implemented using special purpose circuitry (e.g., logic circuitry), with or without software instructions. Embodiments can be implemented using hardwired circuitry without software instructions, or in combination with software instructions. Thus, the techniques are not limited to any specific combination of hardware circuitry and software, nor to any particular source for the instructions executed by a computing device.

While some embodiments can be implemented in fully functioning computers and computer systems, various embodiments are capable of being distributed as a computing product in a variety of forms and are capable of being applied regardless of the particular type of computer-readable medium used to actually effect the distribution.

At least some aspects disclosed can be embodied, at least in part, in software. That is, the techniques may be carried out in a computing device or other system in response to its processing device, such as a microprocessor, executing sequences of instructions contained in a memory, such as ROM, volatile RAM, non-volatile memory, cache or a remote storage device.

Routines executed to implement the embodiments may be implemented as part of an operating system, middleware, service delivery platform, SDK (Software Development Kit) component, web services, or other specific application, component, program, object, module or sequence of instructions (sometimes referred to as computer programs). Invocation interfaces to these routines can be exposed to a software development community as an API (Application Programming Interface). The computer programs typically comprise one or more instructions set at various times in various memory and storage devices in a computer, and that, when read and executed by one or more processors in a computer, cause the computer to perform operations necessary to execute elements involving the various aspects.

A computer-readable medium can be used to store software and data which when executed by a computing device causes the device to perform various methods. The executable software and data may be stored in various places including, for example, ROM, volatile RAM, non-volatile memory and/or cache. Portions of this software and/or data may be stored in any one of these storage devices. Further, the data and instructions can be obtained from centralized servers or peer to peer networks. Different portions of the data and instructions can be obtained from different centralized servers and/or peer to peer networks at different times and in different communication sessions or in a same communication session. The data and instructions can be obtained in entirety prior to the execution of the applications. Alternatively, portions of the data and instructions can be obtained dynamically, just in time, when needed for execution. Thus, it is not required that the data and instructions be on a computer-readable medium in entirety at a particular instance of time.

Examples of computer-readable media include, but are not limited to, recordable and non-recordable type media such as volatile and non-volatile memory devices, read only memory (ROM), random access memory (RAM), flash memory devices, solid-state drive storage media, removable disks, magnetic disk storage media, optical storage media (e.g., Compact Disk Read-Only Memory (CD ROMs), Digital Versatile Disks (DVDs), etc.), among others. The computer-readable media may store the instructions. Other examples of computer-readable media include, but are not limited to, non-volatile embedded devices using NOR flash or NAND flash architectures. Media used in these architectures may include un-managed NAND devices and/or managed NAND devices, including, for example, eMMC, SD, CF, UFS, and SSD.

In general, a non-transitory computer-readable medium includes any mechanism that provides (e.g., stores) information in a form accessible by a computing device (e.g., a computer, mobile device, network device, personal digital assistant, manufacturing tool having a controller, any device with a set of one or more processors, etc.). A "computer-readable medium" as used herein may include a single medium or multiple media (e.g., that store one or more sets of instructions).

In various embodiments, hardwired circuitry may be used in combination with software and firmware instructions to implement the techniques. Thus, the techniques are neither limited to any specific combination of hardware circuitry and software nor to any particular source for the instructions executed by a computing device.

Various embodiments set forth herein can be implemented using a wide variety of different types of computing devices. As used herein, examples of a "computing device" include, but are not limited to, a server, a centralized computing platform, a system of multiple computing processors and/or components, a mobile device, a user terminal, a vehicle, a personal communications device, a wearable digital device, an electronic kiosk, a general purpose computer, an electronic document reader, a tablet, a laptop computer, a smartphone, a digital camera, a residential domestic appliance, a television, or a digital music player. Additional examples of computing devices include devices that are part of what is called "the internet of things" (IOT). Such "things" may have occasional interactions with their owners or administrators, who may monitor the things or modify settings on these things. In some cases, such owners or administrators play the role of users with respect to the "thing" devices. In some examples, the primary mobile device (e.g., an Apple iPhone) of a user may be an administrator server with respect to a paired "thing" device that is worn by the user (e.g., an Apple watch).

In some embodiments, the computing device can be a computer or host system, which is implemented, for example, as a desktop computer, laptop computer, network server, mobile device, or other computing device that includes a memory and a processing device. The host system can include or be coupled to a memory sub-system so that the host system can read data from or write data to the memory sub-system. The host system can be coupled to the memory sub-system via a physical host interface. In general, the host system can access multiple memory sub-systems via a same communication connection, multiple separate communication connections, and/or a combination of communication connections.

In some embodiments, the computing device is a system including one or more processing devices. Examples of the processing device can include a microcontroller, a central processing unit (CPU), special purpose logic circuitry (e.g., a field programmable gate array (FPGA), an application specific integrated circuit (ASIC), etc.), a system on a chip (SoC), or another suitable processor.

In one example, a computing device is a controller of a memory system. The controller includes a processing device and memory containing instructions executed by the processing device to control various operations of the memory system.

Although some of the drawings illustrate a number of operations in a particular order, operations which are not order dependent may be reordered and other operations may be combined or broken out. While some reordering or other groupings are specifically mentioned, others will be apparent to those of ordinary skill in the art and so do not present an exhaustive list of alternatives. Moreover, it should be recognized that the stages could be implemented in hardware, firmware, software or any combination thereof.

Disjunctive language such as the phrase "at least one of X, Y, or Z," unless specifically stated otherwise, is otherwise understood with the context as used in general to present that an item, term, etc., may be either X, Y, or Z, or any combination thereof (e.g., X, Y, and/or Z). Thus, such disjunctive language is not generally intended to, and should not, imply that certain embodiments require at least one of X, at least one of Y, or at least one of Z to each be present.

In the foregoing specification, the disclosure has been described with reference to specific exemplary embodiments thereof. It will be evident that various modifications may be made thereto without departing from the broader scope as set forth in the following claims. The specification and drawings are, accordingly, to be regarded in an illustrative sense rather than a restrictive sense.

## Claims

1. An apparatus comprising:
a memory array (102) comprising ternary cells (105); and
at least one controller (120) configured to store data in the ternary cells, wherein the data corresponding to a defined value is stored using two levels of coding, and other remaining data is stored using one level of coding.

2. The apparatus of claim 1, wherein the data comprises bit combinations (1204, 1208), the bit combinations (1204) corresponding to the defined value are stored using the two levels of coding, and other remaining bit combinations (1208) are stored using the one level of coding.

3. The apparatus of any of the claims 1 to 2, wherein the controller (120) is further configured to receive the data from a host device (126) as part of a write operation requested by the host device.

4. The apparatus of any of the claims 1 to 3, wherein the controller (120) is further configured to select the defined value based on a characteristic of the data.

5. The apparatus of any of the claims 1 to 4, wherein the data includes bit combinations (1204, 1208), and each bit combination is stored using a pair of the ternary cells (105).

6. The apparatus of any of the claims 1 to 5, wherein:
a first bit combination (1204) of the data corresponds to the defined value and is stored in first and second ternary cells, and a state of each of the first and second ternary cells is programmed by the controller based on an additional bit (1206) to be stored; and
the additional bit is associated with the first bit combination.

7. The apparatus of any of the claims 1 to 5, wherein:
the controller (120) is further configured to determine that the data includes a first bit combination (1204) representing the defined value, and in response to determining that the data includes the first bit combination, apply a second level of coding to code an additional bit (1206);
the first bit combination (1204) is stored using first and second ternary cells, and applying the second level of coding comprises selecting a first (LO) or second (L1) state of the first ternary cell of the memory array based on a value represented by the additional bit (1206); and
a programmed state (LO) of the second ternary cell when storing the first bit combination (1204) is the same for either of the first and second states of the first ternary cell.

8. The apparatus of any of the claims 1 to 7, wherein:
the controller (120) is further configured to store the data using a coding table that maps multiple data bits in the data to programmable states for pairs of ternary cells; and
the coding table includes combinations of the programmable states, and one of the combinations is a redundant combination (810; 902) corresponding to the defined value.

9. The apparatus of claim 1, wherein the controller (120) is further configured to:
identify positions (1134, 1136, 1138, 1140) of special values in user data; and
associate a respective additional bit (1150, ..., 1152, ...) to each identified position (1134, ..., 1138, ...).

10. The apparatus of claim 9, wherein the controller (120) is further configured to:
store the user data at the identified positions (1134, 1136, 1138, 1140) using a first level of coding, and store the respective additional bits (1150, ..., 1152, ...) using a second level of coding; and
program, for each additional bit, states of a respective pair of ternary cells based on a value of the additional bit.

11. The apparatus of any of the claims 9 to 10, wherein:
each special value corresponds to a respective bit combination, and associating the respective additional bit (1150, ..., 1152, ...) comprises adding the additional bit to the bit combination; and
the controller (120) is further configured to store each bit combination and corresponding additional bit using a pair of ternary cells.

12. The apparatus of any of the claims 9 to 11, wherein the user data is a basic payload (1130), and the additional bits are an additional payload (1132).

13. The apparatus of any of the claims 1 to 12 wherein the controller (120) is further configured to:
adjust a proportion of special values in first data; and
store, using pairs of the ternary cells, each special value with a respective additional bit.

14. The apparatus of claim 13, wherein the controller (120) is further configured to:
scan the first data;
change, based on the scanning, a distribution of the first data; and
after changing the distribution, coding the first data for storage in the ternary cells.

15. The apparatus of any of the claims 13 to 14, wherein adjusting the proportion comprises:
balancing codewords in the first data to change a distribution of at least one programmed state of the ternary cells;
adjusting the proportion comprises targeting a number of special values in the first data; or
the first data is a basic payload, and adjusting the proportion comprises targeting a quantity of additional payload.
